Europäisches Patentamt

European Patent Office

Office européen des brevets

(19)

(11) Veröffentlichungsnummer: **0 226 890 B1**

(12) **EUROPÄISCHE PATENTSCHRIFT**

(45) Veröffentlichungstag der Patentschrift: 02.10.91

(51) Int. Cl.⁵: **H01L 21/60**, H01L 21/285

(21) Anmeldenummer: 86116736.9

(22) Anmeldetag: 02.12.86

(54) Verfahren zum Herstellen von selbstjustierten Bipolar-Transistorstruksturen mit reduziertem Basisbahnwiderstand.

(30) Priorität: 17.12.85 DE 3544573

(43) Veröffentlichungstag der Anmeldung:
01.07.87 Patentblatt 87/27

(45) Bekanntmachung des Hinweises auf die
Patenterteilung:
02.10.91 Patentblatt 91/40

(84) Benannte Vertragsstaaten:
AT DE FR GB IT NL

(56) Entgegenhaltungen:
EP-A- 0 071 494
EP-A- 0 137 906
DE-A- 3 402 188

IEEE TRANSACTIONS ON ELECTRON DEVI-
CES, Band ED-27, Nr. 8, August 1980, Seiten
1390-1394, IEEE, New York, US; H. NAKASHI-
BA et al.: "An advanced PSA technology for
high-speed bipolar LSI"

JAPANESE JOURNAL OF APPLIED PHYSICS,
Band 20, Supplement 20-1, 1981, Seiten
155-159, Tokyo, JP; T. SAKAI et al.: "High
speed bipolar ICs using super self-aligned
process technology"

(73) Patentinhaber: **Siemens Aktiengesellschaft**
**Wittelsbacherplatz 2**
**W-8000 München 2(DE)**

(72) Erfinder: **Böhm, Willi, Dr.**
**Grunwalder Weg 4**
**W-8025 Unterhaching(DE)**
Erfinder: **Schaber, Hans-Christian, Dr.**
**Ruffiniallee 26**
**W-8032 Gräfelfing(DE)**

## Beschreibung

Die Erfindung betrifft ein Verfahren zum Herstellen von Bipolar-Transistorstrukturen gemäß dem Oberbegriff des Anspruchs 1.

Ein solches Verfahren ist aus der DE-OS 32 43 059 Al bekannt. Dieses Verfahren erlaubt die Herstellung von Bipolar-Transistorschaltungen hoher Packungsdichte mit hohen Schaltgeschwindigkeiten bzw. Gatter mit stark verringerten Gatterlaufzeiten. Als Basisanschlußmaterial wird bei diesen Bipolar-Schaltungen bor-dotiertes Polysilizium verwendet, welches, bedingt durch seine zu geringe Korngröße unerwünscht hohe Schichtwiderstände verursacht, die den äußeren Basisbahnwiderstand dieser selbstjustierten Bipolar-Transistoren bestimmt.

Eine Reduktion des $p^+$(Bor)-dotierten Polysiliziumschichtwiderstandes wird in der DE-OS 34 02 188.Al beschrieben. Dabei werden die bordotierten polykristallinen Siliziumschichten durch ein chemisches Abscheideverfahren aus der Dampfphase im amorphen Zustand hergestellt und bei einem späteren Temperaturprozeß in den polykristallinen Zustand übergeführt. Durch diese Maßnahmen wird eine hohe Korngröße bei glatter Schichtoberfläche erzielt, welche eine Reduktion des Schichtwiderstandes auf ungefähr ein Drittel seines Wertes zur Folge hat.

Eine weitere Möglichkeit zur Reduktion des Basisbahnwiderstandes ist dadurch gegeben, daß bestimmte Layout-Maßnahmen verändert werden. So ist zum Beispiel aus einem Aufsatz von A. Wieder in den Siemens Forschungs- und Entwicklungsberichten 13 (1984), Seiten 246 bis 252, bekannt, den Basisbahnwiderstand durch zwei Basisanschlüsse zu reduzieren.

Aus der europäischen Patentanmeldung EP-A-0 071 494 und aus einem Aufsatz von H. Nakashiba et al in IEEE, Transactions on Electron Devices, Bd. ED-27, No. 8, August 1980, Seiten 1390 bis 1394 ist bekannt, den Basisbahnwiderstand dadurch zu reduzieren, daß auf einen Basisanschluß aus Polysilizium eine Silizidschicht aufgebracht wird. Dabei wird nach der Herstellung des Emitteranschlusses, der aus einer zweiten dotierten Polysiliziumschicht besteht und vom Basisanschluß durch eine den Basisanschluß bedeckende Siliziumoxidschicht isoliert ist, eine Photolackmaske erzeugt, die den Emitteranschluß sicher überlappt. Mit Hilfe dieser Photolackmaske wird die Oberfläche des Basisanschlusses teilweise freigelegt und nach Entfernung der Photolackmaske mit Silizid versehen. Dieses Verfahren erhöht wegen der erforderlichen zusätzlichen Photolackmaske die Prozeßkomplexität.

Die Aufgabe, die der Erfindung zugrundeliegt, besteht in der Herstellung von Bipolar-Transistorstrukturen mit einem Polysiliziumbasisanschluß, bei dem ohne Veränderung des Layouts eine Reduktion des äußeren Basisbahnwiderstandes möglich ist; insbesondere soll der "Umgriff" des Basisanschlusses um den Emitter verbessert werden.

Es ist weiterhin Aufgabe der Erfindung, eine Prozeßfolge anzugeben, die geeignet ist, die obengenannte Bipolar-Transistorstruktur in bekannte CMOS-Prozesse zu integrieren.

Gelöst wird die erfindungsgemäße Aufgabe durch ein Verfahren nach Anspruch 1.

Dabei werden als metallisch leitende Schichten Silizide hochschmelzender Metalle oder hochschmelzende Metalle selbst, wie Tantal, Wolfram oder Platin verwendet.

Durch Erzeugen einer zum Emitterbereich selbstjustierten, ringförmig den Emitter umgebenden metallisch leitenden Schicht wird nicht nur eine drastische Reduktion des äußeren Basisbahnwiderstandes erreicht, sondern es wird insbesondere der "Umgriff" des Basisanschlusses um den Emitter verbessert, das heißt, der Emitterbereich ist im Betrieb in guter Näherung von einer Äquipotentiallinie auf Basispotential umschlossen.

Weitere Ausgestaltungen der Erfindung ergeben sich aus den Unteransprüchen.

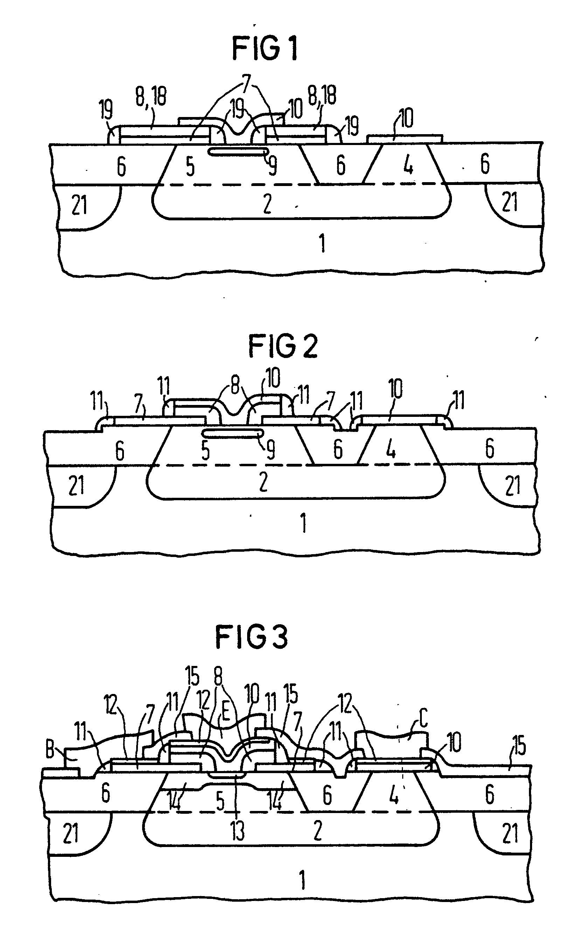

Im folgenden soll anhand eines Ausführungsbeispiels und der Figuren 1 bis 3 der Prozeßablauf zur Herstellung von erfindungsgemäßen Bipolar-Transistoren, bei dem zum Beispiel im p-dotierten Siliziumsubstrat n-dotierte Gebiete erzeugt werden und in die n-dotierten Gebiete isolierte npn-Bipolar-Transistoren gelegt werden, wobei die n-Gebiete den Kollektor des Bipolar-Transistors bilden und bei dem die n-Gebiete vergrabene $n^+$-dotierte Zonen bedecken, die durch tiefreichende Kollektoranschlüsse angeschlossen werden, noch näher beschrieben werden. Dabei sind in den Figuren im Schnittbild nur die erfindungswesentlichen Verfahrensschritte dargestellt.

Figur 1: Die hier abgebildete Anordnung wird durch folgende Verfahrensschritte, welche an und für sich aus dem Stand der Technik bekannt sind (Verfahrensschritte a) bis 1) siehe Siemens Forsch. und Entw. Berichte 13 (1984), Seiten 246 bis 252), erzeugt:

a) Bildung des vergrabenen Kollektorbereiches 2 in einem p-dotierten Siliziumsubstrat 1 durch maskierte Ionenimplantation von Antimon oder Arsen mit einer Dosis und Energie von zum Beispiel $3 \times 10^{15} \mathrm{cm}^{-2}$ und 80 keV,

b) Abscheidung einer $n^-$-dotierten Epitaxieschicht 5 ($1 \times 10^{16}$ As) in einer Schichtdicke von 0,5 bis 2 μm,

c) Durchführung einer Bor-Ionenimplantation oder -Diffusion zur Erzeugung von channel-stopper-Bereichen 21. Diese haben die Funktion, für eine sichere Isolation zwischen benachbarten Kollektorgebieten zu sorgen (Vermeidung eines parasitären Dickoxid-Transistors,

d) Aufbringen einer aus Siliziumoxid und Siliziumnitrid bestehenden Doppelschicht und entsprechende Strukturierung der Siliziumnitridschicht für den nachfolgenden LOCOS-Schritt,

e) Herstellung des für die Trennung der aktiven Transistorbereiche im Substrat 1 erforderlichen Feldoxids 6 durch lokale Oxidation unter Verwendung der bei d) erzeugten Siliziumnitrid-Struktur als Oxidationsmaske,

f) Entfernung der Nitrid/Oxid-Maskierung,

g) Herstellen der Kollektor-Bereiche 4 durch Implantation oder Diffusion von Phosphoratomen nach erfolgter Photolacktechnik,

h) Hochtemperaturschritt (900 bis 1100 °C), wobei auch der Kollektoranschluß 4 bis zum Kollektorbereich 2 eingetrieben wird,

i) ganzflächige Abscheidung einer $p^+$ -leitenden ersten Schicht 7 aus Polysilizium,

j) ganzflächige Abscheidung einer ersten Isolationsschicht 8,

k) Durchführung einer Photolacktechnik und Strukturierung der beiden Schichten 7, 8 mit senkrechten Flanken bis zur Freilegung des Substrats 1 mittels eines Trockenätzverfahrens zur Definition des Basisbereiches,

l) Herstellung des aktiven Basisbereiches 9 durch Bor-Ionen-Implantation,

m) Abscheidung einer zweiten Isolationsschicht 18 und Rückätzen dieser Schicht zur Erzeugung von Flankenisolationen 19 (spacern) an den $p^+$-Polysiliziumkanten 7,

n) ganzflächige Abscheidung einer zweiten Polysiliziumschicht 10 und

o) Durchführung einer Photolacktechnik und Strukturierung der zweiten Polysiliziumschicht 10 so, daß der Emitter-und Kollektoranschluß auf dem Substrat 1 gebildet wird.

Die Feldoxid- oder Dickoxidbereiche können auch durch andere bekannte Verfahren, wie Silizium-Tiefätzen und lokale Oxidation (planare Oberflächen) oder durch Grabenätzen und Auffüllen mit Isolationsmaterial (trench isolation) hergestellt werden.

Figur 2: Unter Verwendung der für die Strukturierung der zweiten Polysiliziumschicht 10 vorhandenen Photolackmaske (nicht dargestellt) oder mit der Polysiliziumschicht 10 selbst als Maske wird nun ein anisotroper Ätzprozeß (reaktives Ionenätzen in einem Trifluormethan-Sauerstoff (CHF₃/O₂)-Gasgemisch) durchgeführt, bei dem die die erste Polysiliziumschicht 7 bedeckende Isolatorschicht 8 bis zur Freilegung der $p^+$-leitenden ersten Polysiliziumschicht 7 entfernt wird. Die Photolackmaske wird, falls nicht schon vorher geschehen, abgelöst und eine gut kantenbedeckende weitere Isolationsschicht (11), vorzugsweise aus SiO₂ (spacer oxid) aufgebracht. Diese spacer oxid-Schicht (11) wird durch eine anisotrope Ätzung zum Beispiel durch reaktives Ionenätzen in einem CHF₃/O₂-Gasgemisch so strukturiert, daß nur an den Flanken der ersten, mit dem ersten Spaceroxid 19 versehenen Polysiliziumschichtstrukturen 7 und der zweiten Polysiliziumschichtstrukturen 10 laterale Isolationsstege 11 stehenbleiben.

Abschließend erfolgt, wenn nicht schon bei der Abscheidung durchgeführt, die Dotierung der zweiten Polysiliziumschicht 10 durch eine Arsen-Ionen-Implantation, wobei alle übrigen Bereiche mit einer Photolackmaskierung versehen werden. Die Arsenimplantation in diesem Stadium des Prozesses ist insbesondere bei der Kombination des erfindungsgemäßen Verfahrens mit einem CMOS-Prozeß zur Herstellung von Bipolar/CMOS-Schaltungen von großem Vorteil, da sich damit gleichzeitig die $n^+$-Source-Drain Gebiete herstellen lassen.

Figur 3: Diese Anordnung entsteht durch folgende Verfahrensschritte:

a) selektive Abscheidung einer metallisch leitenden Schicht 12, zum Beispiel aus Wolfram oder aus Tantalsilizid, wie sie beispielsweise in dem deutschen Patent 32 11 752 C2 beschrieben wird, oder selektive Erzeugung einer Silizidschicht, wie zum Beispiel aus dem Aufsatz von C. Y. Ting in IEDM Technical Digest (1984), Seiten 110 bis 113 bekannt, auf den durch die anisotrope Ätzung freigelegten Siliziumoberflächen der Polysiliziumschichtstrukturen 7 und 10,

b) Temperaturschritt zum Eindiffundieren von Emitter 13- und Basisbereich 14 sowie zur Bildung eines stabilen Silizids 12 auf den Emitter-, Basis- und Kollektoranschlußgebieten (7, 10) bei ca. 900 °C in ca. 30 Minuten und

c) Abscheidung des Zwischenoxids 15, Kontaktlochtechnik und Metallisierung der Emitter (E)-, Basis (B)- und Kollektor-Anschlüsse (C) nach bekannten Standardprozeßschritten.

In einer Variante der eben beschriebenen Prozeßfolge kann der Temperaturschritt für die Eindiffusion von Basis und Emitter (13, 14) auch vor der selektiven Metall- oder Silizidabscheidung (12) erfolgen. Dadurch wird die Verwendung eines nicht hochtemperaturbeständigen Metalles bzw. Silizids, wie zum Beispiel Platinsilizid für die selbstjustierte Kontaktierung möglich gemacht. Der Prozeß ist damit voll mit der gebräuchlichen Platinsilizid/Titan-Wolfram/Aluminium-Metallisierung kompatibel.

Bezugszeichenliste

| 1 | Siliziumsubstrat |
|---|---|
| 2 | vergrabener Kollektorbereich |
| 4 | Kollektorbereich |
| 5 | $n^-$-dotierte Epitaxieschicht |
| 6 | Feldoxid |
| 7 | $p^+$-leitende erste Polysiliziumschicht |

8     erste Isolationsschicht

9     aktiver Basisbereich

10    zweite Polysiliziumschicht

11    Isolationsschicht (spacer oxid)

12    metall. leitende Schicht

13    Emitterbereich 13

14    Basisbereich 14

15    Zwischenoxid 15

18    zweite Isolationsschicht

19    Flankenisolationsschicht (spacer oxid)

21    $p^+$-dotierte Bereiche

## Patentansprüche

1. Verfahren zum Herstellen von Bipolar-Transistorstrukturen mit selbstjustierten Emitter-Basisbereichen, bei dem:
   - der Basisbereich in einem Siliziumhalbleitersubstrat durch Ausdiffusion einer ersten, aus einer ersten dotierten Polysiliziumschicht bestehenden, direkt auf dem Substrat abgeschiedenen Struktur erzeugt wird, die einen Basisanschluß bildet,
   - der Emitterbereich in dem Siliziumhalbleitersubstrat durch Ausdiffusion einer zweiten, aus einer zweiten dotierten Polysiliziumschicht bestehenden, auf der freiliegenden Oberfläche des Substrats und teilweise der Oberfläche einer Isolationsstruktur, die den Basisanschluß vollständig abdeckt, angeordneten Struktur erzeugt wird, die später einen Emitteranschluß bildet,
   - unter Verwendung von $SiO_2$-Schichten als Maskierungs- und Isolationsschichten zunächst der Basisbereich und dann der Emitterbereich zentral in diesem erzeugt werden, daß unter dem Emitterbereich eine aktive Basiszone und ringförmig darum eine inaktive Basiszone entsteht,
   - bei der Strukturierung der $SiO_2$-Schichten und Polysiliziumschichten vertikale Ätzprofile erzeugende Trockenätzverfahren verwendet werden,

   **gekennzeichnet durch** folgende Schritte:
   - nach der Herstellung des Emitteranschlusses (10) durch Strukturierung der zweiten Polysiliziumschicht wird unter Verwendung des Emitteranschlusses (10) als Maske die den Basisanschluß (7) bedeckende Isolationsstruktur (8, 18) in einem Ätzprozeß bis zur Freilegung der Oberfläche des Basisanschlusses (7) entfernt,
   - an den freiliegenden Flanken des Emitteranschlusses (10) und des Basisanschlusses (7) werden Flankenisolationsschichten (11) erzeugt,
   - die freiliegenden Siliziumoberflächen des Basisanschlusses (7) und des Emitteranschlusses (10) werden selektiv mit einer metallisch leitenden Schicht (12) versehen.

2. Verfahren nach Anspruch 1, **dadurch gekennzeichnet,** daß die metallisch leitende Schicht (12) aus einem Silizid eines hochschmelzenden Metalles gebildet wird.

3. Verfahren nach Anspruch 1, **dadurch gekennzeichnet,** daß die metallisch leitende Schicht (12) aus Wolfram oder Platinsilizid gebildet wird.

4. Verfahren nach Anspruch 1,
   **gekennzeichnet durch** den Ablauf folgender Verfahrensschritte:
   a) Herstellen von vergrabenen $n^+$-dotierten Zonen (2) in einem p-dotierten Substrat (1) durch Implantation von n-dotierenden Ionen nach vorheriger Maskierung der übrigen Bereiche,
   b) Abscheidung einer $n^-$-dotierten Epitaxieschicht (5) in einer Schichtdicke von 0.5 bis 2.0 μm,
   c) Durchführung einer Bor-Ionenimplantation oder -Diffusion zur Erzeugung von channel stopper-Bereichen (21),
   d) Aufbringen einer aus Siliziumoxid und Siliziumnitrid bestehenden Doppelschicht und entsprechende Strukturierung der Siliziumnitridschicht für die nachfolgende lokale Oxidation (LOCOS),
   e) Herstellung des für die Trennung der aktiven Transistorbereiche im Substrat (1) erforderlichen Feldoxids (6) durch lokale Oxidation nach Entfernung der Photolackmaske und unter Verwendung der Siliziumnitrid-Struktur als Oxidationsmaske,
   f) Entfernung der Nitrid/Oxid-Maskierung,
   g) Herstellung der Kollektorbereiche (4) durch Implantation oder Diffusion von Phosphoratomen nach erfolgter Photolacktechnik,
   h) Durchführung einer Hochtemperaturbehandlung,
   i) ganzflächige Abscheidung einer $p^+$-leitenden, ersten Schicht (7) aus Polysilizium,
   j) ganzflächige Abscheidung einer Isolationsschicht (8),
   k) Durchführung einer Photolacktechnik und Strukturierung der beiden Schichten (7, 8) mit senkrechten Flanken bis zur Freilegung des Substrats (1) mittels eines Trockenätzverfahrens zur Definition des Basisbereiches (B),

l) Herstellung des aktiven Basisbereiches (9) durch Bor-Ionen-Implantation,

m) Abscheidung einer zweiten Isolationsschicht (18) und Rückätzen dieser Schicht zur Erzeugung von Flankenisolationen (19) an den p$^+$-Polysiliziumkanten (7),

n) ganzflächige Abscheidung einer zweiten Polysiliziumschicht (10),

o) Durchführung einer Photolacktechnik und Strukturierung der zweiten Schicht (10) so, daß der Emitter-und Kollektoranschluß auf dem Substrat (1) gebildet wird,

p) Durchführung eines anisotropen Ätzprozesses, bei dem unter Verwendung des Emitteranschlusses (10) als Ätzmaske die die p$^+$-leitende erste Polysiliziumschicht (7) bedeckende Isolatorschicht (8) bis zur Freilegung der p$^+$-leitenden ersten Polysiliziumschichtoberfläche (7) entfernt wird,

q) ganzflächige Abscheidung einer die Strukturen der p$^+$-leitenden ersten Polysiliziumschicht (7) und die Strukturen der zweiten Polysiliziumschicht (10) gut kantenbedeckenden weiteren Isolationsschicht (11),

r) anisotrope Ätzung dieser weiteren Isolationsschicht (11), wobei an den Flanken der ersten (7) und der zweiten Polysiliziumschicht (10) Isolationsstege (11) entstehen und Siliziumoberflächen der ersten (7) und zweiten Polysiliziumschicht (10) freigelegt werden,

s) Durchführung einer Arsen-Ionen-Implantation im Emitter- und Kollektorbereich der zweiten Polysiliziumschicht (10) nach vorheriger Maskierung der übrigen Bereiche,

t) selektive Abscheidung bzw. Bildung einer Metallschicht (12) oder einer Silizidschicht (12) nach Entfernung der Maskierung auf den freiliegenden Silizium-Oberflächen (7, 10),

u) Durchführung eines Hochtemperaturschrittes, wobei die mit Metall oder Silizid belegten Oberflächen (12) in eine stabile Silizidschicht übergeführt werden und die Dotierstoffe aus der ersten (7) und zweiten Polysiliziumschichtstruktur (10) in das Siliziumsubstrat (1) eindiffundiert werden, und

v) Erzeugung einer als Isolationsoxid (15) dienenden Zwischenschicht, Öffnen der Kontaktlöcher zu den aus den dotierten Polysiliziumstrukturen bestehenden Anschlüsse der aktiven Transistorbereiche in bekannter Weise.

5. Verfahren nach Anspruch 4, **dadurch gekennzeichnet,** daß der Hochtemperaturschritt bei ca. 900° C in 30 Minuten durchgeführt wird.

6. Verfahren nach Anspruch 4, **dadurch gekennzeichnet,** daß der Hochtemperaturschritt in einer Schocktemperung (rapid annealing) durchgeführt wird, wobei eine Temperatur im Bereich von 1000 bis 1200° C für eine Zeitdauer von maximal 60 sec eingestellt wird.

7. Verfahren nach Anspruch 4, **dadurch gekennzeichnet,** daß der Verfahrensschritt u) vor dem Verfahrensschritt t) durchgeführt wird.

**Claims**

1. Method for the fabrication of bipolar transistor structures with self-aligned emitter-base regions, in which:

   - the base region is produced in a silicon semiconductor substrate by diffusing out a first structure, deposited directly on the substrate and consisting of a first doped polysilicon layer, which forms a base connection,

   - the emitter region is produced in the silicon semiconductor substrate by diffusing out a second structure, consisting of a second doped polysilicon layer on the exposed surface of the substrate and partially on the surface of an insulating structure which completely covers the base connection, which structure will later form an emitter connection,

   - using SiO$_2$ layers as masking and insulation layers, first of all the base region is produced and then the emitter region is produced centrally in the base region, such that an active base zone is produced under the emitter region with an annular inactive base zone around it,

   - in producing the structure of the SiO$_2$ layers and polysilicon layers dry etching methods are used that create vertical etching profiles,

   characterised by the following steps:

   - after fabrication of the emitter connection (10) by producing the structure of the second polysilicon layer, the insulating structure (8, 18) covering the base connection (7) is removed in an etching process, using the emitter connection (10) as a mask, until the surface of the base connection (7) is exposed,

   - edge insulating layers (11) are produced on the exposed edges of the emitter connection (10) and of the base connection (7),

   - the exposed silicon surfaces of the base connection (7) and of the emitter connection (10) are selectively coated with a metallic conductive layer (12).

2. Method according to Claim 1, characterised in that the metallic conductive layer (12) is formed from a silicide of a high melting point metal.

3. Method according to Claim 1, characterised in that the metallic conductive layer (12) is formed from tungsten or platinum silicide.

4. Method according to Claim 1, characterised by the following sequence of steps according to the method:

a) fabrication of buried $n^+$-doped zones (2) in a p-doped substrate (1) by the implantation of n-doped ions following previous masking of the remaining regions,

b) deposition of an $n^-$-doped epitaxial layer (5) to a layer thickness of 0.5 to 2.0 $\mu$m,

c) implementation of a boron ion implantation or diffusion for the production of channel stopper regions (21),

d) application of a double layer, consisting of silicon oxide and silicon nitride, and appropriate structuring of the silicon nitride layer for the subsequent local oxidation (LOCOS),

e) fabrication of the field oxide (6) required for isolation of the active transistor regions in the substrate (1), by local oxidation after removal of the photo-resist mask and using the silicon nitride structure as an oxidation mask,

f) removal of the nitride/oxide masking,

g) fabrication of the collector regions (4) by implantation or diffusion of phosphorus atoms after a photo-resist technique has been carried out,

h) implementation of high-temperature treatment,

i) deposition, over the entire surface, of a $p^+$-conductive, first layer (7) of polysilicon,

j) deposition, over the entire surface, of an insulation layer (8),

k) Implementation of a photo-resist technique and structuring of the two layers (7, 8) with vertical edges down to exposure of the substrate (1) by means of a dry etching process for definition of the base region (B),

l) fabrication of the active base region (9) by boron ion implantation,

m) deposition of a second insulation layer (18) and back-etching of this layer for the production of edge insulation areas (19) on the $p^+$-polysilicon edges (7),

n) deposition, over the entire surface, of a second polysilicon layer (10),

o) implementation of a photo-resist technique and structuring of the second layer (10) such that the emitter and collector connection are formed on the substrate (1),

p) implementation of an anisotropic etching process in which, using the emitter connection (10) as an etching mask, the insulating layer (8) covering the $p^+$-conductive first polysilicon layer (7) is removed down to exposure of the $p^+$-conductive first polysilicon layer surface (7),

q) deposition, over the entire surface, of a further insulating layer (11) which provides a good covering over the edges of the structures of the $p^+$-conductive first polysilicon layer (7) and of the structures of the second polysilicon layer (10),

r) anisotropic etching of the further insulation layer (11), such that insulation webs (11) are formed on the edges of the first (7) and of the second polysilicon layer (10) and the silicon surfaces of the first (7) and second polysilicon layer (10) are exposed,

s) implementation of an arsenic ion implantation in the emitter and collector region of the second polysilicon layer (10) following previous masking of the remaining regions,

t) selective deposition and formation of a metal layer (12) or of a silicide layer (12) after removal of the masking on the exposed silicon surfaces (7, 10),

u) implementation of a high-temperature step, the surfaces (12) which are coated with metal or silicide being carried over into a stable silicide layer and the doping materials from the first (7) and second polysilicon layer structure (10) being diffused into the silicon substrate (1), and

v) production of an intermediate layer, serving as an insulation oxide (15), opening of the contact holes for the connections of the active transistor regions, consisting of the doped polysilicon structures, in a known manner.

5. Method according to Claim 4, characterised in that the high-temperature step is carried out at about 900 $^\circ$C in 30 minutes.

6. Method according to Claim 4, characterised in that the high-temperature step is carried out as rapid annealing, a temperature in the range from 1000 to 1200 $^\circ$C being selected for a maximum time period of 60 sec.

7. Method according to Claim 4, characterised in that step u) of the method is carried out before step t) of the method.

## Revendications

1. Procédé pour fabriquer des structures de transistors bipolaires comportant des zones d'émetteur et de base auto-alignées, et selon lequel:
   - on forme la région de base dans un substrat semiconducteur en silicium par diffusion d'une première structure constituée par une première couche de silicium dopée, déposée directement sur le substrat et qui forme une borne de base,
   - on forme la région d'émetteur dans le substrat semiconducteur en silicium par diffusion d'une seconde structure constituée par une seconde couche de silicium dopée et disposée sur la surface nue du substrat et en partie sur la surface d'une structure d'isolation qui recouvre la borne de base et qui forme ultérieurement une borne d'émetteur,
   - moyennant l'utilisation de couches de $SiO_2$ en tant que couches de masquage et d'isolation, on forme tout d'abord la région de base, puis la région d'émetteur dans une position centrée dans la région précédente de manière à obtenir, au-dessous de la région d'émetteur, une zone de base active et, entourant cette dernière selon une disposition annulaire, une zone de base inactive,
   - lors de la structuration des couches de $SiO_2$ et des couches de silicium polycristallin, on utilise des procédés de corrosion à sec produisant des profils de corrosion verticaux,

   caractérisé par les étapes suivantes:
   - après la fabrication de la borne d'émetteur (10) par structuration de la seconde couche de polysilicium, on élimine, en utilisant la borne d'émetteur (10) en tant que masque, la structure d'isolation (8,18), qui recouvre la borne de base (7), lors d'un processus de corrosion jusqu'à la mise à nu de la surface de la borne de base (7),
   - sur les flancs nus de la borne d'émetteur (10) et de la borne de base (7), on forme des couches (11) d'isolation de ces flancs,
   - on dépose de façon sélective une couche métallique conductrice (12) sur les surfaces nues de silicium de la borne de base (7) et de la borne d'émetteur (10).

2. Procédé suivant la revendication 1, caractérisé par le fait qu'on forme la couche métallique conductrice (12) en utilisant un siliciure d'un métal à point de fusion élevé.

3. Procédé suivant la revendication 1, caractérisé par le fait qu'on forme la couche métallique conductrice (12) en utilisant du tungstène ou un siliciure de platine.

4. Procédé selon la revendication 1, caractérisé par l'exécution des étapes opératoires suivants:
   a) fabrication de zones ensevelies (2) dopées du type $n^+$ dans un substrat (1) dopé de type p, par implantation d'ions réalisant un dopage de type n, après masquage préalable des autres régions,
   b) dépôt d'une couche épitaxiale (5) dopée du type $n^-$, sur une épaisseur de couche comprise entre 0,5 et 2,0 $\mu$m,
   c) exécution d'une implantation ou d'une diffusion d'ions de bore pour la production de zones d'arrêt de canal (21),
   d) dépôt d'une couche double formée d'oxyde de silicium et de nitrure de silicium et structuration correspondante de la couche de nitrure de silicium pour l'oxydation locale (LOCOS) ultérieure,
   e) fabrication de l'oxyde de champ (6), qui est nécessaire pour la séparation des régions actives du transistor, par oxydation locale après élimination du masque de laque photosensible et moyennant l'utilisation de la structure de nitrure de silicium en tant que masque d'oxydation,
   f) élimination du masque de nitrure/oxyde,
   g) fabrication des régions de collecteur (4) par implantation ou diffusion d'atomes de phosphore, après mise en oeuvre d'une technique utilisant une laque photosensible,
   h) exécution d'un traitement à haute température,
   i) dépôt, sur toute la surface, d'une première couche (7) de polysilicium, conductrice du type $p^+$,
   j) dépôt, sur toute la surface, d'une couche isolante (8),
   k) mise en oeuvre d'une technique utilisant une laque photosensible et structuration des deux couches (7,8) possédant des flancs perpendiculaires, jusqu'à la mise à nu du substrat (1), au moyen d'un procédé de corrosion à sec pour la définition de la région de base (B),
   l) fabrication de la région active de base (9) par implantation d'ions de bore,
   m) dépôt d'une seconde couche isolante (18) et rétrocorrosion de cette couche pour la production d'isolations (19) sur les flancs (7) du polysilicium de type $p^+$,

n) dépôt, sur toute la surface, d'une seconde couche de polysilicium (10),

o) mise en oeuvre d'une technique utilisant une laque photosensible et structuration de la seconde couche (10) pour la formation des bornes d'émetteur et de collecteur sur le substrat (1),

p) exécution d'un procédé de corrosion anisotrope, lors duquel, moyennant l'utilisation de la borne d'émetteur (10) en tant que masque de corrosion, on élimine la couche isolante (8) qui recouvre la première couche de polysilicium (7) conductrice du type $p^+$, jusqu'à la mise à nu de la première surface (7) de la couche de polysilicium conductrice du type $p^+$,

q) dépôt, sur toute la surface, d'une autre couche isolante (11) qui recouvre bien les bords des structures de la première couche de polysilicium (7) conductrice de type $p^+$ et les structures de la seconde couche de polysilicium (10),

r) corrosion anisotrope de cette autre couche isolante (11), lors de laquelle des barrettes isolantes (11) apparaissent au niveau des flancs de la première couche de polysilicium (7) et de la seconde couche de polysilicium (10) et des surfaces de silicium de la première couche de polysilicium (7) et de la seconde couche de polysilicium (10) sont mises à nu,

s) mise en oeuvre d'une implantation d'ions d'arsenic dans les zones d'émetteur et de collecteur de la seconde couche de polysilicium (10) après masquage préalable des autres zones,

t) dépôt sélectif et formation d'une couche métallique (12) ou d'une couche de siliciure (12) après élimination du masquage sur les surfaces nues de silicium (7,10),

u) exécution d'une étape de traitement à haute température, lors de laquelle les surfaces (12) recouvertes d'un métal ou d'un siliciure sont converties en une couche de siliciure stable et les substances dopantes provenant de la première structure (7) de couche de polysilicium et de la seconde structure (10) de couche de polysilicium pénètrent par diffusion dans le substrat en silicium (1), et

v) production d'une couche intercalaire utilisée comme oxyde isolant (15), ouverture des trous de contact aboutissant aux bornes, constituées par les structures en polysilicium dopé, des zones actives du transistor, d'une manière connue.

5. Procédé suivant la revendication 4, caractérisé par le fait que l'étape de traitement à haute température est exécutée à environ 900°C pendant trente minutes.

6. Procédé suivant la revendication 4, caractérisé par le fait que l'étape de traitement à haute température est exécutée sous la forme d'un recuit brusque (rapid annealing), moyennant le réglage à une température dans la gamme comprise entre 1000 et 1200°C pendant une durée égale au maximum à 60 s.

7. Procédé suivant la revendication 4, caractérisé par le fait qu'on exécute l'étape opératoire u) avant l'étape opératoire t).

# FIG 1

# FIG 2

# FIG 3